# EUROPEAN PATENT SPECIFICATION

(11) **EP 4 621 839 B1**
(45) Date of publication and mention of the grant of the patent: **16.09.2026**
(21) Application number: 24165436.7
(22) Date of filing: 22.03.2024
(51) Int. Cl.: H10W 20/00, H10W 20/42

(54) **SPLIT CONDUCTIVE VIA FABRICATION**
HERSTELLUNG VON GETEILTEN LEITENDEN VIAS
FABRICATION DES INTERCONNEXIONS VERTICALES DÉDOUBLÉES

(43) Date of publication of application: 24.09.2025
(73) Proprietor: Imec VZW, 3001 Leuven (BE)
(72) Inventor: PARK, Seongho, 3001 Heverlee (BE); TOKEI, Zsolt, 3000 Leuven (BE)
(74) Representative: Winger

(56) References cited:
- EP-A1- 4 199 052
- US-A1- 2023 011 088
- US-A1- 2023 326 986
- US-A1- 2023 420 296

## Description

### Field of the Invention

The present invention pertains to the field of semiconductor device fabrication, specifically to methods for forming integrated circuits with improved conductive via structures.

### Background of the Invention

The field of semiconductor manufacturing is one that has seen relentless progress over the past several decades, driven by the industry's ability to continuously scale down the size of transistors and the interconnects that link them together. This miniaturization has been essential to increasing the performance and functionality of electronic devices while reducing their power consumption and cost. The process of scaling is governed by a set of design rules known as ground rules (GRs), which dictate the minimum dimensions and tolerances for the various features that make up a semiconductor device.

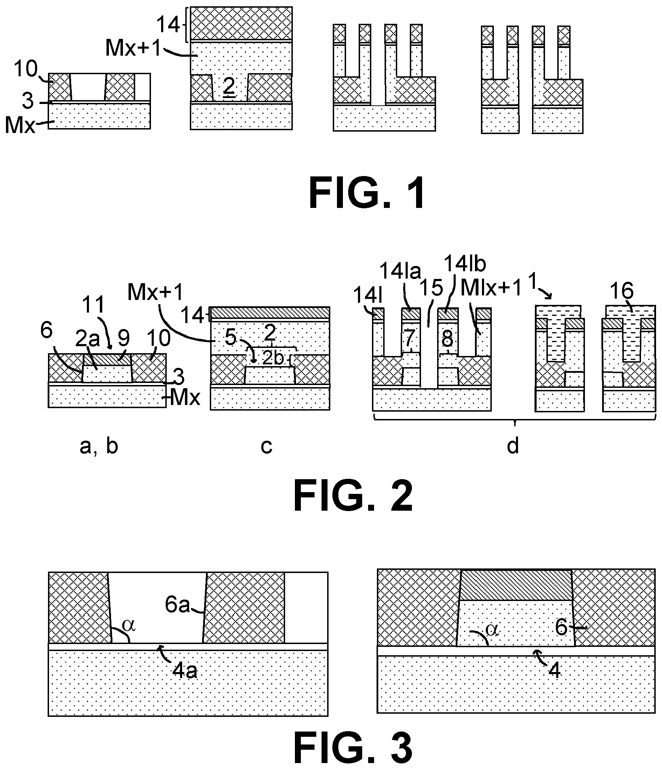

One of the critical aspects of semiconductor fabrication is the formation of conductive vias and metal layers that create the electrical connections between different parts of the integrated circuit. As devices have become more complex and the demand for higher performance has increased, the industry has faced significant challenges in maintaining the pace of scaling. These challenges are particularly evident in the context of the Copper Dual-Damascene (Cu DD) process, which has been the standard approach for forming these connections. Fig. 1 portrays a sequence of four diagrams that illustrate the stages of the dual damascene process, a method for forming metal interconnections within an integrated circuit.

In the first diagram, enlarged in Fig. 3 (left), we observe at the bottom a first electrically conductive layer (Mx). This electrically conductive layer (Mx) is covered by a conductive barrier layer (3). On top of the conductive barrier layer (3), there's a dielectric material (10), in which via holes have been patterned using a mask (14). These via holes are designed to eventually house the electrically conductive material that will form the circuit's conductive vias (2). The via holes have a bottom surface (4a) and sloped sidewalls (6a) wherein the angle (α) between the bottom surface (4a) and the sidewalls (6a) is above 90° all around the periphery of the bottom surface (4a).

The second diagram shows the subsequent stage where an electrically conductive material, typically copper, has been deposited into the openings, filling them, thereby forming the conductive vias (2). The conductive material also covers the entire assembly, indicating an overfill forming an interconnect layer (Mx+1) above and in contact with the conductive via (2). A masking material (14) is provided on top of the interconnect layer (Mx+1).

In the third diagram, the masking material (14) has been patterned and used as a mask (14) to etch through the interconnect layer (Mx+1) and the conductive via (2), thereby splitting it in two.

The fourth and final diagram illustrates the result after a further etching step, where the barrier layer and the first electrically conductive line (Mx) have been split as well.

In the Cu DD process, conductive vias often extend beyond the metal layers (Mx and Mx+1), which can lead to inefficiencies in the use of space within the semiconductor layout and/or short-circuits. The conductive via center-to-center (C2C) spacing is limited by lithographic capabilities, which restricts how closely these vias can be placed to one another. Similarly, the trench-to-trench (T2T) spacing is constrained by both lithography and etching processes. These limitations become more pronounced as the industry pushes towards smaller pitches, testing the limits of current manufacturing technologies.

Alignment offsets and etching selectivity are concerns that can impact the yield and performance of semiconductor devices. As pitches shrink, the alignment accuracy between different layers and features becomes increasingly critical. Any misalignment can lead to defects and functional failures, making the manufacturing process more complex and costly.

Despite the advancements in lithography and etching techniques, there is a recognition within the industry that the traditional Cu DD process may not be sufficient to meet the demands of future scaling. The challenges associated with conductive via imperfect overlap, C2C spacing, and T2T spacing highlight the need for new approaches that can overcome these hurdles.

The concept of self-aligning conductive vias to metal layers has been known as a potential way to achieve more efficient use of space within the semiconductor layout. However, the practical implementation of this concept faces significant challenges, particularly as the industry continues to scale down to smaller nodes.

In light of these challenges, there is a clear need for further advancements in the field of semiconductor manufacturing that address some or all of these challenges.

A prior art method for forming self-aligned split vias is known from the document EP 4 199 052 A1, commonly assigned to the same applicant as the present application.

### Summary of the Invention

It is an object of embodiments of the present invention to enable tight conductive via-to-conductive via and trench-to-trench spacing in semiconductor fabrication. This objective is accomplished by a method for forming an integrated circuit or an intermediate in the formation thereof according to claim 1.

In the first aspect, the present invention relates to a method for forming an integrated circuit or an intermediate in the formation thereof, the method comprising the steps of a. providing a second electrically conductive layer over a first electrically conductive line and in electrical contact therewith, then b. etching the second electrically conductive layer so as to form at least a lower part of an electrically conductive via having a bottom surface having a first area, an exposed top surface having a second area, smaller than the first area, and sidewalls, typically sloped sidewalls, connecting the bottom surface to the top surface, wherein the angle between the bottom surface and the sidewalls is less than 90° all around the periphery of the bottom surface, c. forming a third electrically conductive layer on said at least a lower part of the electrically conductive via, thereby making electrical contact with said exposed top surface and electrically connecting the first electrically conductive line with the third electrically conductive layer, and d. etching through the third electrically conductive layer, the electrically conductive via, and the first electrically conductive line, so as to form i. a set of electrically conductive lines from the third electrically conductive layer, said electrically conductive lines being separated by gaps, ii. splitting the electrically conductive via into a first split electrically conductive via, and a second split electrically conductive via, and iii. splitting the first electrically conductive line.

In embodiments, step b. of the method may further comprise i. providing a hard mask over a region of the second electrically conductive layer; ii. etching the second electrically conductive layer by using the hard mask as an etching guide, thereby forming the lower part of the electrically conductive via; wherein step c. comprises i. depositing a dielectric material to fill a gap around the lower part of the electrically conductive via, so as to expose a top surface of the hard mask; ii. removing the hard mask, thereby leaving a hole exposing the top surface of the lower part of the electrically conductive via; and iii. forming an upper part of the electrically conductive via in addition to the third electrically conductive layer, wherein the upper part of the electrically conductive via is aligned and makes electrical contact with the top surface of the lower part of the electrically conductive via. An advantage of this embodiment is that it provides an example of a practical implementation of the first aspect, providing a precise method for forming the electrically conductive via with a controlled shape and size.

In embodiments, the hard mask may have a thickness of from 1 to 5 nm. A hard mask with a thickness as small as possible is advantageous as it allows step c to be performed without having to fill too large a gap left by the removal of the hard mask. This avoids defect creation during step c.

In embodiments where it is used, the dielectric material may be a silicon oxide. The advantage of this embodiment is that silicon oxide is a commonly used dielectric material that provides good electrical insulation and compatibility with semiconductor processes.

In embodiments, step c.i may comprise depositing a dielectric material to fill a gap around the lower part of the electrically conductive via and to cover the hard mask, followed by planarizing the dialectical material by chemical mechanical planarization so as to expose the top surface of the hard mask. The advantage of this embodiment is that it ensures a smooth and level surface for subsequent processing steps.

In embodiments, the width of the bottom surface of the via may be from 3 to 3.5 times larger than the width of the lines of the set of electrically conductive lines. The use of a large pillar conductive via obtained by a subtractive method can lead to a larger interface between metal layers and the conductive vias, which may result in a larger process window and less variation of conductive via resistance. In particular, it allows for the formation of two vias, after splitting, with a sufficiently large bottom surface, which can improve the electrical connection to the first electrically conductive line Mx and reduce resistance.

In embodiments, the method may comprise d1. providing a hard mask comprising a set of parallel lines separated by gaps, said lines being in physical contact with a top surface of the third electrically conductive layer, two of said lines overlapping with the electrically conductive via so that the width of a vertical projection of the gap between both lines on the top surface of the electrically conductive via is comprised in that top surface, and then d2. etching (i) the third electrically conductive layer, (ii) the electrically conductive via, and (iii) the first electrically conductive line, by using the hard mask lines as an etching guide. The advantage of this embodiment is that it provides a method for precisely defining the location and size of the gap between the split vias.

In embodiments, the hard mask may comprise Si₃N₄. The advantage of this embodiment is that silicon nitride is a material with good etch selectivity with respect to metals and with good mechanical properties, making it suitable for use as a hard mask.

In embodiments, the hard mask may further comprise a TiN layer between the Si₃N₄ and the third electrically conductive layer. The advantage of this embodiment is that the TiN layer can act as a diffusion barrier and improve the adhesion between the hard mask and the conductive layer.

In embodiments, the method may comprise providing a semiconductor structure comprising two transistor structures, the first electrically conductive line extending above at least part of each transistor structure, a second electrically conductive via electrically connecting the first electrically conductive line with a first of the transistor structures, and a third electrically conductive via electrically connecting the first electrically conductive line with a second of the transistor structures. This is an example of application of the first aspect. It integrates the formation of the electrically conductive vias with the underlying transistor structures, facilitating the creation of complex integrated circuits.

In embodiments, the method may further comprise covering with a masking material a portion of the first electrically conductive line which is not exposed by a gap while leaving the gap uncovered. The advantage of this embodiment is that it protects certain areas of the conductive line during etching, allowing for more precise patterning.

In embodiments, the masking material may be a spin-on carbon material. The advantage of this embodiment is that spin-on carbon provides a uniform coating and can be easily applied to the substrate.

In embodiments, the second electrically conductive layer, the first electrically conductive line, and the third electrically conductive layer may be made of Cu, W, Mo, or Ru, preferably Ru. The advantage of this embodiment is that these materials provide good electrical conductivity and are compatible with semiconductor processing.

In embodiments, a conductive barrier layer may be provided between the second electrically conductive layer and the first electrically conductive line. The advantage of this embodiment is that the barrier layer can improve the reliability of the electrical connection.

In embodiments, the conductive barrier layer may be a TiN layer. The advantage of this embodiment is that titanium nitride is a well-known conductive barrier material that provides good adhesion and barrier properties.

In embodiments, the present invention relates to a method for forming an integrated circuit for use in a device selected from the group consisting of a computer processor, a memory chip, and a sensor. This embodiment highlights the broad applicability of the method to various types of electronic devices.

It is an advantage of embodiments of the present invention that the challenges associated with conductive via overlap in conventional Copper Dual-Damascene processes can be mitigated. It is a further advantage of embodiments of the present invention that the limitations of conductive via center-to-center spacing, dictated by lithographic capabilities, can be overcome. It is yet another advantage of embodiments of the present invention that trench-to-trench spacing can be reduced, supporting the trend of continuous scaling in semiconductor fabrication. It is an additional advantage of embodiments of the present invention that alignment offsets, which are critical considerations in semiconductor manufacturing, can be addressed more effectively. It is also an advantage of embodiments of the present invention that the use of a split conductive via enables tighter conductive via-to-conductive via and trench-to-trench spacing. It is a further advantage of embodiments of the present invention that the semi-damascene process allows for configurations not feasible in traditional Copper Dual-Damascene processes. It is another advantage of embodiments of the present invention that the use of a large pillar conductive via obtained by a subtractive method can lead to a larger interface between metal layers and the conductive vias, which may result in a larger process window and less variation of conductive via resistance. It is an additional advantage of embodiments of the present invention that the angle between the bottom surface and the sidewalls of the conductive via can be at most 90 degrees, enhancing the electrical contact between layers. It is also an advantage of embodiments of the present invention that the process may lead to more efficient use of space within the semiconductor layout, potentially improving the performance of semiconductor devices at smaller scales.

Particular and preferred aspects of the invention are set out in the accompanying independent and dependent claims. Features from the dependent claims may be combined with features of the independent claims and with features of other dependent claims as appropriate and not merely as explicitly set out in the claims.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig.1 is a cross-sectional view of a series of intermediates in the fabrication of a semiconductor structure, illustrating the dual damascene process of the prior art.
Fig.2 is a cross-sectional view of a series of intermediates in the fabrication of a semiconductor structure, illustrating the process according to an embodiment of the present invention.
Fig.3 is a comparative cross-sectional view comparing the angle (α) obtained in the prior art (left) and in the present invention (right).
Fig.4 is a flowchart of the method for forming an integrated circuit or an intermediate in the formation thereof according to embodiments of the present invention.

In the different figures, the same reference signs refer to the same or analogous elements.

### Detailed description of Illustrative Embodiments

The present invention will be described with respect to particular embodiments and with reference to certain drawings, but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top and over and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", also used in the claims, should not be interpreted as being restricted to the means listed thereafter; it does not exclude other elements or steps. It is thus to be interpreted as specifying the presence of the stated features, integers, steps, or components as referred to, but does not preclude the presence or addition of one or more other features, integers, steps or components, or groups thereof. Thus, the scope of the expression "a device comprising means A and B" should not be interpreted as being limited to devices consisting only of components A and B. It means that with respect to the present invention, the only relevant components of the device are A and B. The term "comprising" therefore covers the situation where only the stated features are present and the situation where these features and one or more other features are present. The word "comprising" according to the invention therefore also includes as one embodiment that no further components are present. When the word "comprising" is used to describe an embodiment in this application, it is to be understood that an alternative version of the same embodiment, wherein the term "comprising" is replaced by "consisting of", is also encompassed within the scope of the present invention.

Reference throughout this specification to "one embodiment" or "an embodiment" means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, well-known methods, structures, and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

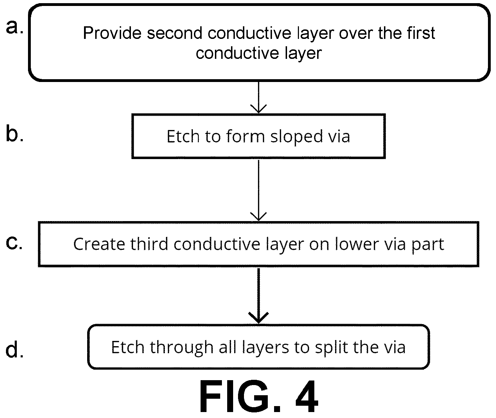

We now refer to Figs. 2 and 4. Fig. 2 is a cross-sectional view of a semiconductor structure illustrating the process according to an embodiment of the present invention, showing the etched lower part (2a) of an electrically conductive via (2) with sloped sidewalls (6) and a third electrically conductive layer (Mx+1) formed on it. Fig. 4 is a flowchart of the method for forming an integrated circuit or an intermediate (1) in the formation thereof according to embodiments of the present invention, outlining the steps of the method, including (a) the provision of the second conductive layer over the first conductive line or layer, (b) etching the second conductive layer to form a via with an angle (α) of at most 90°, preferably a sloped via with an angle (α) below 90°, (c) creating a third conductive layer on the lower via part, and (d) the formation of the split electrically conductive vias by etching.

The present invention relates to a method for forming an integrated circuit or an intermediate (1) in the formation thereof. The method includes providing a second electrically conductive layer (not depicted) over a first electrically conductive line (Mx) and in electrical contact therewith. The first electrically conductive line (Mx) can be part of a first electrically conductive layer. The first electrically conductive layer can comprise a plurality of parallel first electrically conductive lines (Mx). The second electrically conductive layer is etched to form at least a lower part (2a) of an electrically conductive via (2). This via has a bottom surface (4) with a first area, an exposed top surface (5) with a second area smaller than the first area, and sloped sidewalls, connecting the bottom surface (4) to the top surface (5). The angle (α) between the bottom surface (4) and the sidewalls (6) is less than 90°, all around the periphery of the bottom surface (4), as illustrated in Fig. 3, which compares the angle (α) obtained in the prior art (left) with the present invention (right). The right image of Fig. 3 shows the via according to the present invention, where the angle (α) between the bottom surface (4) and the sidewalls (6) is less than 90°, resulting in a larger interface between the first electrically conductive line (Mx) (or the conductive barrier layer (3) thereon) and the electrically conductive vias (2).

A third electrically conductive layer (Mx+1) is formed on the lower part (2a) of the electrically conductive via (2), making electrical contact with the exposed top surface (5) and electrically connecting the first electrically conductive line (Mx) with the third electrically conductive layer (Mx+1). The third electrically conductive layer (Mx+1), the electrically conductive via (2), and the first electrically conductive line (Mx) are then etched to form a set of electrically conductive lines (Mlx+1) separated by gaps (15), splitting the electrically conductive via into a first and a second split electrically conductive via (7, 8), and splitting the first electrically conductive line (Mx). This "split conductive via" enables tighter conductive via-to-conductive via and trench-to-trench spacing, supporting continuous scaling in semiconductor fabrication.

As used herein, and unless otherwise specified, the term "integrated circuit or an intermediate" refers to a complete electronic circuit with various components such as transistors, resistors, capacitors, and the interconnects between them, or to a partially completed structure of such a circuit that is in the process of being fabricated. Examples of specific embodiments include but are not limited to microprocessors, memory chips, digital signal processors, and application-specific integrated circuits (ASICs).

As used herein, and unless otherwise specified, the term "electrically conductive layer or line" refers to, respectively, a layer or a line of material that has the ability to conduct electric current. This term encompasses layers made of metals, metal alloys, conductive oxides, or any other materials known to have conductive properties. Examples of specific embodiments include layers made of copper (Cu), tungsten (W), molybdenum (Mo), ruthenium (Ru), aluminum (Al), and their alloys. These electrically conductive layers or lines can be deposited by method well known to the person skilled in the art such as ALD or CVD.

In embodiments, the first electrically conductive line (Mx) may be embedded in a dielectric material such as SiO₂. In embodiments, the first electrically conductive line (Mx) may be provided as part of a set of parallel first electrically conductive lines (Mx), all arranged within a first metallization level and each extending along a same first direction.

As used herein, and unless otherwise specified, the term "electrically conductive via" refers to a structure oriented vertically that provides an electrical connection between different layers of an integrated circuit. The via is composed of conductive material and is characterized by having a bottom surface, an exposed top surface, and typically sloped sidewalls.

In the fabrication process, the formation of an electrically conductive via involves step b of etching the second electrically conductive layer so as to form at least a lower part of an electrically conductive via. This etching facilitates the creation of a via with an inclined profile, wherein the sidewalls form an angle of less than 90 degrees with respect to the base. This precise angulation can be achieved through direct metal etch, which halts upon reaching the etch stop layer that resides atop the underlying Mx lines. The direct metal etch techniques can be adapted to various electrically conductive materials such as Copper (Cu), Ruthenium (Ru), Molybdenum (Mo), and Tungsten (W), among others. This is well known to the person skilled in the art. Direct metal etch techniques typically involve exposing the electrically conductive material to a chemically reactive plasma. Examples of direct metal etch techniques are reactive ion etching and atomic layer etching. Depending on the material composition of the conductive layer, suitable etchant gases and conditions can be selected. For instance, when the layer is composed of Ru, Chlorine (Cl₂) or a combination of Oxygen (O₂) with Cl₂ may be employed as the etchant, e.g., in an inductively coupled plasma etching chamber. This non-traditional approach of forming the via, characterized by its sidewalls angled at lower than 90° offers a significant advantage over the conventional damascene process, which typically involves dielectric etching followed by metal filling. The unique angle of the via not only facilitates a more efficient electrical connection but also provides a larger process window, enhancing the reliability and performance of the semiconductor device.

The term "at least a lower part of the electrically conductive via" encompasses both incomplete vias and complete vias. When only a lower part of the electrically conductive via is formed, the height of this lower part is preferably at least 90 % of the height of the entire via obtained after step c.

The angle (α) between the bottom surface (4) and the sidewalls (6) is less than 90°.

Preferably it is from 80 to 88°. This angle can be determined by TEM imaging.

In embodiments, step b. of the method may include i. providing a hard mask (9) over a region of the second electrically conductive layer. The hard mask provided in step b. i. is patterned so as to comprise a through hole. The shape of the through hole will determine the shape of the via hole, and hence the shape of the electrically conductive via. This shape can, for instance, be circular or square. The hard mask (9) is used as an etching guide to form the lower part (2a) of the electrically conductive via (2) during etching step ii..

As used herein, and unless otherwise specified, the term "hard mask" refers to a layer of material that is resistant to etching processes and is used to define patterns during the etching of underlying layers. The hard mask serves as a protective barrier in selected areas while allowing the removal of unprotected material. Examples of specific embodiments include hard masks made of silicon nitride (Si₃N₄), silicon carbide (SiC), titanium nitride (TiN), and other materials known for their etch resistance.

The hard mask (9) may have a thickness of from 1 to 5 nm. It may comprise Si₃N₄ or may further comprise a TiN layer between the Si₃N₄ and the third electrically conductive layer (Mx+1).

Typically, step c. comprises forming either a third electrically conductive layer (Mx+1) having a flat bottom surface when the at least a lower part of the electrically conductive via is the whole final electrically conductive via, or a third electrically conductive layer (Mx+1) penetrating a via hole in a dielectric material (10), said via hole exposing the lower part of the electrically conductive via, thereby forming the upper part of the electrically conductive via, when the at least a lower part of the electrically conductive via is only a lower part of the electrically conductive via. Forming the third electrically conductive layer (Mx+1) can for instance be performed by PVD, CVD, or ALD.

As used herein, and unless otherwise specified, the term "dielectric material" refers to a non-conductive material that is used to electrically isolate different conductive elements within an integrated circuit. This material is used to fill gaps and spaces between conductive features. Examples of specific embodiments include silicon oxide (SiO₂), low-k dielectrics, high-k dielectrics, and other insulating materials commonly used in semiconductor fabrication.

During step c.i., a dielectric material (10), which may for instance be a silicon oxide, is deposited to fill a gap around the lower part (2a) of the electrically conductive via (2), so as to expose a top surface (11) of the hard mask (9). The hard mask (9) is then removed in step c.ii., leaving a hole exposing the top surface (5) of the lower part (2a) of the electrically conductive via (2). An upper part (2b) of the electrically conductive via (2) is then formed in step c.iii. in addition to the third electrically conductive layer (Mx+1), wherein the upper part of the electrically conductive via (2) is aligned and makes electrical contact with the top surface (5) of the lower part (2a) of the electrically conductive via (2).

Embodiments of the invention's process flow involves etch, gap fill, Chemical Mechanical Planarization (CMP), oxide recess, and optional hard mask (HM) (e.g., Silicon Nitride (Si₃N₄)) removal (10).

One way to ensure that the dielectric material fills the gap around the lower part of the electrically conductive via while also exposing a top surface of the hard mask is to proceed by chemical mechanical planarization (CMP).

As used herein, and unless otherwise specified, the term "chemical mechanical planarization" (CMP) refers to a process that combines application of an excess of a material, e.g., a dielectric material, followed by a mechanical polishing to flatten and smooth the surface of the applied material, thereby removing excess material and ensuring a uniform surface for subsequent processing steps. Examples of specific embodiments include CMP processes for planarizing dielectric layers, metal layers, and barrier layers. This process is used to planarize the topography of the material and is particularly useful when the applied material is meant to be coplanar with features of the substrate on which it has been applied.

The dielectric material (10) may be planarized by chemical mechanical planarization to expose the top surface (11) of the hard mask (9).

The width of the bottom surface (4) of the via (2) may be from 3 to 3.5 times larger than the width of the lines of the set of electrically conductive lines (Mlx+1), specifying the conductive via critical dimension (CD) as three to three and a half times the CD of the Mx+1 layer (11).

Step c.iii. can be performed as described earlier, i.e., by forming either a third electrically conductive layer (Mx+1) having a flat bottom surface when the at least a lower part of the electrically conductive via is the whole final electrically conductive via, or a third electrically conductive layer (Mx+1) penetrating a via hole in a dielectric, said via hole exposing the lower part of the electrically conductive via, thereby forming the upper part of the electrically conductive via, when the at least a lower part of the electrically conductive via is only a lower part of the electrically conductive via.

In embodiments the set of electrically conductive lines (Mlx+1) formed in step d.i. may have a width of from 5 to 20 nm.

Typically, the pitch of the set of parallel lines (14l) is the same as the pitch of the set of electrically conductive lines (Mlx+1).

In embodiments, the width of the split created in step d. ii. may be from 0.4 to 0.6 times, e.g., 0.5 times, the pitch of the set of electrically conductive lines (Mlx+1).

In embodiments, the distance separating the first split electrically conductive via (7), and the second split electrically conductive via (8) may be from 0.4 to 0.6 times, e.g., 0.5 times, the pitch of the set of electrically conductive lines (Mlx+1).

In embodiments, the width of each of the first split electrically conductive via (7), and a second split electrically conductive via (8) may be from 5 to 13 nm.

In embodiments, the distance separating the first split electrically conductive via (7) and a second split electrically conductive via (8) may be from 5 to 13 nm.

In some embodiments, step d. of the method may include d1. providing a hard mask (14) comprising a set of parallel lines (14I) separated by gaps. These lines (14I) are in physical contact with a top surface of the third electrically conductive layer (Mx+1), and two of the lines (14la, 14lb) overlap with the electrically conductive via (2). The width of a vertical projection of the gap between both lines (14la, 14lb) on the top surface of the electrically conductive via (2) is comprised in that top surface. The third electrically conductive layer (Mx+1) and the electrically conductive via (2) are then etched using the hard mask lines (14l) as an etching guide. This approach proposes a self-aligning conductive via to metal layers for efficient space use within the semiconductor layout (6).

In embodiments, the set of parallel lines (14I) may be equidistant.

The method may also include providing a semiconductor structure comprising two transistor structures, with the first electrically conductive line (Mx) extending above at least part of each transistor structure. A second electrically conductive via electrically connects the first electrically conductive line (Mx) with a first of the transistor structures, and a third electrically conductive via electrically connects the first electrically conductive line (Mx) with a second of the transistor structures. A portion of the first electrically conductive line (Mx) which is not exposed by a gap (15) may be covered with a masking material, such as a spin-on carbon material, while leaving the gap (15) uncovered.

As used herein, and unless otherwise specified, the term "semiconductor structure" refers to a structure that includes semiconductor devices and the associated interconnects and layers that form part of an integrated circuit. Examples of specific embodiments include structures containing transistor devices such as metal-oxide-semiconductor field-effect transistors (MOSFETs), bipolar junction transistors (BJTs), FinFETs, GAA FETs, and CFETs, among others.

As used herein, and unless otherwise specified, the term "masking material" refers to a material applied to protect certain areas of a semiconductor wafer during processing steps such as etching or implantation. This material prevents modification of the underlying areas while allowing processing of exposed regions. Examples of specific embodiments include photoresist materials, spin-on carbon materials, and hard masks.

In embodiments, the second electrically conductive layer, the first electrically conductive line (Mx), and the third electrically conductive layer (Mx+1) may be made of Cu, W, Mo, or Ru, preferably Ru.

In embodiments, a conductive barrier layer (3), which may be a TiN layer, can be provided between the second electrically conductive layer and the first electrically conductive line (Mx). Ruthenium (Ru) deposition after etching to the next metal layer (Mx+1) is included in the process (12).

As used herein, and unless otherwise specified, the term "conductive barrier layer" refers to a thin layer of conductive material that is used as an etch stop layer and which can, in some embodiments, enhance adhesion between different materials in an integrated circuit. Examples of specific embodiments include barrier layers made of titanium nitride (TiN), tantalum nitride (TaN), and other materials known for their conductive and barrier properties.

In embodiments, the method of the present invention may be for forming an integrated circuit for use in a device selected from the group consisting of a computer processor, a memory chip, and a sensor.

## Claims

1. A method for forming an integrated circuit or an intermediate (1) in the formation thereof, the method comprising the steps of:
a. Providing a second electrically conductive layer over a first electrically conductive line (Mx) and in electrical contact therewith, then
b. Etching the second electrically conductive layer so as to form at least a lower part (2a) of an electrically conductive via (2) having a bottom surface (4) having a first area, an exposed top surface (5) having a second area, smaller than the first area, and sidewalls (6) connecting the bottom surface (4) to the top surface (5), wherein the angle (α) between the bottom surface (4) and the sidewalls (6) is less than 90° all around the periphery of the bottom surface (4), then
c. Forming a third electrically conductive layer (Mx+1) on said at least a lower part (2a) of the electrically conductive via (2), thereby making electrical contact with said exposed top surface (5) and electrically connecting the first electrically conductive line (Mx) with the third electrically conductive layer (Mx+1), then
d. Etching through the third electrically conductive layer (Mx+1), the electrically conductive via (2), and the first electrically conductive line (Mx), so as to:
i. forming a set of electrically conductive lines (Mlx+1) from the third electrically conductive layer (Mx+1), said electrically conductive lines (Mlx+1) being separated by gaps (15),
ii. splitting the electrically conductive via (2) into a first split electrically conductive via (7), and a second split electrically conductive via (8), and
iii. splitting the first electrically conductive line (Mx).

2. The method according to claim 1,
wherein step b comprises:
i. Providing a hard mask (9) over a region of the second electrically conductive layer;
ii. Etching the second electrically conductive layer by using the hard mask (9) as an etching guide, thereby forming the lower part (2a) of the electrically conductive via (2);
Wherein step c. comprises:
i. Depositing a dielectric material (10) to fill a gap around the lower part (2a) of the electrically conductive via (2), so as to expose a top surface (11) of the hard mask (10);
ii. Removing the hard mask (10), thereby leaving a hole exposing the top surface (5) of the lower part (2a) of the electrically conductive via (2); and
iii. Forming an upper part (2b) of the electrically conductive via (2) in addition to the third electrically conductive layer (Mx+1), wherein the upper part of the electrically conductive via (2) is aligned and makes electrical contact with the top surface (5) of the lower part (2a) of the electrically conductive via (2).

3. The method according to claim 2, wherein the hard mask (9) has a thickness of from 1 to 5 nm.

4. The method according to claim 2 or claim 3, wherein the dielectric material (10) is a silicon oxide.

5. The method according to any one of claims 2 to 4, wherein step c.i. comprises depositing a dielectric material (10) to fill a gap around the lower part (2a) of the electrically conductive via (2) and to cover the hard mask (9), followed by planarizing the dielectric material (10) by chemical mechanical planarization so as to expose the top surface (11) of the hard mask (9).

6. The method according to any one of the preceding claims, wherein the width of the bottom surface (4) of the via (2) is from 3 to 3.5 times larger than the width of the lines of the set of electrically conductive lines (Mlx+1).

7. The method according to any one of the preceding claims, wherein step d comprises:
d1. Providing a hard mask (14) comprising a set of parallel lines (14I) separated by gaps, said lines (14I) being in physical contact with a top surface of the third electrically conductive layer (Mx+1), two (14la, 14lb) of said lines (14I) overlapping with the electrically conductive via (2) so that the width of a vertical projection of the gap between both lines (14la, 14lb) on the top surface of the electrically conductive via (2) is comprised in that top surface, and then
d2. Etching (i) the third electrically conductive layer (Mx+1), (ii) the electrically conductive via (2), and (iii) the first electrically conductive line (Mx) by using the hard mask lines (14l) as an etching guide.

8. The method according to claim 7, wherein the hard mask comprises Si₃N₄.

9. The method according to claim 8, wherein the hard mask further comprises a TiN layer between the Si₃N₄ and the third electrically conductive layer (Mx+1).

10. The method according to any one of the preceding claims, wherein step a comprises providing a semiconductor structure comprising:
i. two transistor structures,
ii. the first electrically conductive line (Mx) extending above at least part of each transistor structure,
iii. a second electrically conductive via electrically connecting the first electrically conductive line (Mx) with a first of the transistor structures, and
iv. a third electrically conductive via electrically connecting the first electrically conductive line (Mx) with a second of the transistor structures.

11. The method according to any one of the preceding claims, further comprising a step d.ii' between step d.ii and step d.iii of covering with a masking material a portion of the first electrically conductive line (Mx) which is not exposed by a gap (15) while leaving the gap (15) uncovered.

12. The method according to claim 11, wherein the masking material is a spin-on carbon material.

13. The method according to any one of the preceding claims, wherein the second electrically conductive layer, the first electrically conductive line (Mx), and the third electrically conductive layer (Mx+1) are made of Ru.

14. The method according to any one of the preceding claims, wherein a conductive barrier layer (3) is provided between the second electrically conductive layer and first electrically conductive line (Mx).

15. The method according to claim 14, wherein the conductive barrier layer (3) is a TiN layer.

## Patentansprüche

1. Ein Verfahren zur Bildung einer integrierten Schaltung oder eines Zwischenprodukts (1) bei der Bildung davon, wobei das Verfahren die Schritte umfasst zum:
a.- Bereitstellen einer zweiten elektrisch leitfähigen Schicht über einer ersten elektrisch leitfähigen Leitung (Mx), und in elektrischem Kontakt damit, danach
b.- Ätzen der zweiten elektrisch leitfähigen Schicht, um mindestens einen unteren Teil (2a) einer elektrisch leitfähigen Durchkontaktierung (2) zu bilden, die eine untere Oberfläche (4) aufweist, die einen ersten Bereich aufweist, eine freiliegende obere Oberfläche (5), die einen zweiten Bereich, kleiner als den ersten Bereich aufweist, und Seitenwände (6), welche die untere Oberfläche (4) mit der oberen Oberfläche (5) verbinden, zu bilden, wobei der Winkel (α) zwischen der unteren Oberfläche (4) und den Seitenwänden (6) um den gesamten Umfang der unteren Oberfläche (4) herum kleiner als 90° ist, danach
c.- Bilden einer dritten elektrisch leitfähigen Schicht (Mx+1) auf dem mindestens einen unteren Teil (2a) der elektrisch leitfähigen Durchkontaktierung (2), wodurch elektrischer Kontakt mit der freiliegenden oberen Oberfläche (5) hergestellt wird, und die erste elektrisch leitfähige Leitung (Mx) mit der dritten elektrisch leitfähigen Schicht (Mx+1) verbunden wird, danach
d.- Ätzen durch die dritte elektrisch leitfähige Schicht (Mx+1), der elektrisch leitfähigen Durchkontaktierung (2) und der ersten elektrisch leitfähigen Leitung (Mx), zum:
i.- Bilden eines Satzes elektrisch leitfähiger Leitungen (Mlx+1) von der dritten elektrisch leitfähigen Schicht (Mx+1), wobei die elektrisch leitfähigen Leitungen (Mlx+1) durch Lücken (15) getrennt sind,
ii.- Teilen der elektrisch leitfähigen Durchkontaktierung (2) in eine erste geteilte elektrisch leitfähige Durchkontaktierung (7) und eine zweite geteilte elektrisch leitfähige Durchkontaktierung (8), und
iii.- Teilen der ersten elektrisch leitfähigen Leitung (Mx).

2. Das Verfahren nach Anspruch 1,
wobei Schritt b umfasst:
i.- Bereitstellen einer Hartmaske (9) über einer Region der zweiten elektrisch leitfähigen Schicht;
ii.- Ätzen der zweiten elektrisch leitfähigen Schicht durch Verwenden der Hartmaske (9) als Ätzführung, wodurch der untere Teil (2a) der elektrisch leitfähigen Durchkontaktierung (2) gebildet wird;
wobei Schritt c. umfasst:
i.- Abscheiden eines dielektrischen Materials (10), um eine Lücke um den unteren Teil (2a) der elektrisch leitfähigen Durchkontaktierung (2) herum zu füllen, um eine obere Oberfläche (11) der Hartmaske (10) freizulegen;
ii.- Entfernen der Hartmaske (10), wodurch ein Loch entsteht, das die obere Oberfläche (5) des unteren Teils (2a) der elektrisch leitfähigen Durchkontaktierung (2) freilegt; und
iii.- Bilden eines oberen Teils (2b) der elektrisch leitfähigen Durchkontaktierung (2) zusätzlich zur dritten elektrisch leitfähigen Schicht (Mx+1), wobei der obere Teil der elektrisch leitfähigen Durchkontaktierung (2) mit der oberen Oberfläche (5) des unteren Teils (2a) der elektrisch leitfähigen Durchkontaktierung (2) ausgerichtet ist und elektrischen Kontakt damit herstellt.

3. Das Verfahren nach Anspruch 2, wobei die Hartmaske (9) eine Dicke von 1 bis 5 nm aufweist.

4. Das Verfahren nach Anspruch 2 oder Anspruch 3, wobei das dielektrische Material (10) Siliziumoxid ist.

5. Das Verfahren nach einem der Ansprüche 2 bis 4, wobei Schritt c.i. Abscheiden eines dielektrischen Materials (10) umfasst, um eine Lücke um den unteren Teil (2a) der elektrisch leitfähigen Durchkontaktierung (2) zu füllen, und um die Hartmaske (9) abzudecken, gefolgt von Ebnen des dielektrischen Materials (10) durch chemischmechanisches Ebnen umfasst, um die obere Oberfläche (11) der Hartmaske (9) freizulegen.

6. Das Verfahren nach einem der vorstehenden Ansprüche, wobei die Breite der unteren Oberfläche (4) der Durchkontaktierung (2) 3- bis 3,5-mal größer ist als die Breite der Leitungen des Satzes elektrisch leitfähiger Leitungen (Mlx+1).

7. Das Verfahren nach einem der vorstehenden Ansprüche, wobei Schritt d umfasst:
d1.- Bereitstellen einer Hartmaske (14), umfassend einen Satz paralleler Leitungen (14l), die durch Lücken getrennt sind, wobei die Leitungen (14l) in physischem Kontakt mit einer oberen Oberfläche der dritten elektrisch leitfähigen Schicht (Mx+1) stehen, zwei (14Ia, 14Ib) der Leitungen (14I) sich mit der elektrisch leitfähigen Durchkontaktierung (2) überlappen, sodass die Breite einer vertikalen Projektion der Lücke zwischen beiden Leitungen (14Ia, 14Ib) auf der oberen Oberfläche der elektrisch leitfähigen Durchkontaktierung (2) in dieser oberen Oberfläche umfasst ist, und danach
d2.- Ätzen (i) der dritten elektrisch leitfähigen Schicht (Mx+1), (ii) der elektrisch leitfähigen Durchkontaktierung (2) und (iii) der ersten elektrisch leitfähigen Leitung (Mx) durch Verwenden der Hartmaskenleitungen (14l) als Ätzführung.

8. Das Verfahren nach Anspruch 7, wobei die Hartmaske Si₃N₄ umfasst.

9. Das Verfahren nach Anspruch 8, wobei die Hartmaske weiter eine TiN-Schicht zwischen dem Si_{3N4} und der dritten elektrisch leitfähigen Schicht (Mx+1) umfasst.

10. Verfahren nach einem der vorstehenden Ansprüche, wobei Schritt a Bereitstellen einer Halbleiterstruktur umfasst, umfassend:
i.- zwei Transistorstrukturen,
ii.- die erste elektrisch leitfähige Leitung (Mx), die sich über mindestens einen Teil jeder Transistorstruktur erstreckt,
iii.- eine zweite elektrisch leitfähige Durchkontaktierung, welche die erste elektrisch leitfähige Leitung (Mx) elektrisch mit einer ersten der Transistorstrukturen verbindet, und
iv.- eine dritte elektrisch leitfähige Durchkontaktierung, welche die erste elektrisch leitfähige Leitung (Mx) elektrisch mit einer zweiten der Transistorstrukturen verbindet.

11. Das Verfahren nach einem der vorstehenden Ansprüche, weiter umfassend einen Schritt d.ii' zwischen Schritt d.ii und Schritt d.iii, zum Abdecken eines Abschnitts der ersten elektrisch leitfähigen Leitung (Mx), der nicht von einer Lücke (15) freigelegt ist, mit einem Abdeckmaterial, während die Lücke (15) unbedeckt bleibt.

12. Das Verfahren nach Anspruch 11, wobei das Abdeckmaterial ein aufgeschleudertes Kohlenstoffmaterial ist.

13. Das Verfahren nach einem der vorstehenden Ansprüche, wobei die zweite elektrisch leitfähige Schicht, die erste elektrisch leitfähige Leitung (Mx) und die dritte elektrisch leitfähige Schicht (Mx+1) aus Ru gefertigt sind.

14. Das Verfahren nach einem der vorstehenden Ansprüche, wobei zwischen der zweiten elektrisch leitfähigen Schicht und der ersten elektrisch leitfähigen Leitung (Mx) eine leitfähige Barriereschicht (3) bereitgestellt ist.

15. Das Verfahren nach Anspruch 14, wobei die leitfähige Barriereschicht (3) eine TiN-Schicht ist.

## Revendications

1. Une méthode de formation d'un circuit intégré ou d'un intermédiaire (1) dans la formation de celui-ci, la méthode comprenant les étapes suivantes :
a. Fournir une deuxième couche électriquement conductrice au-dessus d'une première ligne électriquement conductrice (Mx) et en contact électrique avec celle-ci, puis
b. Graver la deuxième couche électriquement conductrice de manière à former au moins une partie inférieure (2a) d'un via électriquement conducteur (2) présentant une surface inférieure (4) d'une première superficie, une surface supérieure exposée (5) d'une deuxième superficie inférieure à la première superficie, et des parois latérales (6) reliant la surface inférieure (4) à la surface supérieure (5), dans laquelle l'angle (α) entre la surface inférieure (4) et les parois latérales (6) est inférieur à 90° tout autour de la périphérie de la surface inférieure (4), puis
c. Former une troisième couche électriquement conductrice (Mx+1) sur ladite au moins une partie inférieure (2a) du via électriquement conducteur (2), établissant ainsi un contact électrique avec ladite surface supérieure exposée (5) et reliant électriquement la première ligne électriquement conductrice (Mx) à la troisième couche électriquement conductrice (Mx+1), puis
d. Graver à travers la troisième couche électriquement conductrice (Mx+1), le via électriquement conducteur (2), et la première ligne électriquement conductrice (Mx), de manière à :
i. former un ensemble de lignes électriquement conductrices (Mlx+1) à partir de la troisième couche électriquement conductrice (Mx+1), lesdites lignes électriquement conductrices (Mlx+1) étant séparées par des espaces (15),
ii. diviser le via électriquement conducteur (2) en un premier via électriquement conducteur divisé (7) et un deuxième via électriquement conducteur divisé (8), et
iii. diviser la première ligne électriquement conductrice (Mx).

2. La méthode selon la revendication 1,
dans laquelle l'étape b comprend :
i. Fournir un masque dur (9) au-dessus d'une région de la deuxième couche électriquement conductrice ;
ii. Graver la deuxième couche électriquement conductrice en utilisant le masque dur (9) comme guide de gravure, formant ainsi la partie inférieure (2a) du via électriquement conducteur (2) ;
dans laquelle l'étape c comprend :
i. Déposer un matériau diélectrique (10) pour combler un espace autour de la partie inférieure (2a) du via électriquement conducteur (2), de manière à exposer une surface supérieure (11) du masque dur (9) ;
ii. Retirer le masque dur (9), laissant ainsi un orifice exposant la surface supérieure (5) de la partie inférieure (2a) du via électriquement conducteur (2) ; et
iii. Former une partie supérieure (2b) du via électriquement conducteur (2) en complément de la troisième couche électriquement conductrice (Mx+1), dans laquelle la partie supérieure du via électriquement conducteur (2) est alignée et établit un contact électrique avec la surface supérieure (5) de la partie inférieure (2a) du via électriquement conducteur (2).

3. La méthode selon la revendication 2, dans laquelle le masque dur (9) a une épaisseur de 1 à 5 nm.

4. La méthode selon la revendication 2 ou la revendication 3, dans laquelle le matériau diélectrique (10) est un oxyde de silicium.

5. La méthode selon l'une quelconque des revendications 2 à 4, dans laquelle l'étape c.i comprend le dépôt d'un matériau diélectrique (10) pour combler un espace autour de la partie inférieure (2a) du via électriquement conducteur (2) et pour recouvrir le masque dur (9), suivi d'une planarisation du matériau diélectrique (10) par planarisation mécano-chimique de manière à exposer la surface supérieure (11) du masque dur (9).

6. La méthode selon l'une quelconque des revendications précédentes, dans laquelle la largeur de la surface inférieure (4) du via (2) est de 3 à 3,5 fois supérieure à la largeur des lignes de l'ensemble de lignes électriquement conductrices (Mlx+1).

7. La méthode selon l'une quelconque des revendications précédentes, dans laquelle l'étape d comprend :
d1. Fournir un masque dur (14) comprenant un ensemble de lignes parallèles (14I) séparées par des espaces, lesdites lignes (14I) étant en contact physique avec une surface supérieure de la troisième couche électriquement conductrice (Mx+1), deux desdites lignes (14la, 14lb) se chevauchant avec le via électriquement conducteur (2) de sorte que la largeur d'une projection verticale de l'espace entre les deux lignes (14la, 14lb) sur la surface supérieure du via électriquement conducteur (2) soit comprise dans cette surface supérieure, puis
d2. Graver (i) la troisième couche électriquement conductrice (Mx+1), (ii) le via électriquement conducteur (2), et (iii) la première ligne électriquement conductrice (Mx) en utilisant les lignes de masque dur (14I) comme guide de gravure.

8. La méthode selon la revendication 7, dans laquelle le masque dur comprend du Si₃N₄.

9. La méthode selon la revendication 8, dans laquelle le masque dur comprend en outre une couche de TiN entre le Si₃N₄ et la troisième couche électriquement conductrice (Mx+1).

10. La méthode selon l'une quelconque des revendications précédentes, dans laquelle l'étape a comprend la fourniture d'une structure semiconductrice comprenant :
i. deux structures de transistors,
ii. la première ligne électriquement conductrice (Mx) s'étendant au-dessus d'au moins une partie de chaque structure de transistor,
iii. un deuxième via électriquement conducteur reliant électriquement la première ligne électriquement conductrice (Mx) à une première des structures de transistors, et
iv. un troisième via électriquement conducteur reliant électriquement la première ligne électriquement conductrice (Mx) à une deuxième des structures de transistors.

11. La méthode selon l'une quelconque des revendications précédentes, comprenant en outre une étape d.ii' entre l'étape d.ii et l'étape d.iii consistant à recouvrir d'un matériau de masquage une partie de la première ligne électriquement conductrice (Mx) qui n'est pas exposée par un espace (15), tout en laissant l'espace (15) découvert.

12. La méthode selon la revendication 11, dans laquelle le matériau de masquage est un matériau carbone déposé par enduction centrifuge.

13. La méthode selon l'une quelconque des revendications précédentes, dans laquelle la deuxième couche électriquement conductrice, la première ligne électriquement conductrice (Mx) et la troisième couche électriquement conductrice (Mx+1) sont constituées de Ru.

14. La méthode selon l'une quelconque des revendications précédentes, dans laquelle une couche barrière conductrice (3) est interposée entre la deuxième couche électriquement conductrice et la première ligne électriquement conductrice (Mx).

15. La méthode selon la revendication 14, dans laquelle la couche barrière conductrice (3) est une couche de TiN.
